# EUROPÄISCHE PATENTSCHRIFT

(11) **EP 2 534 092 B1**
(45) Veröffentlichungstag und Bekanntmachung des Hinweises auf die Patenterteilung: **11.12.2013**
(21) Anmeldenummer: 10792943.2
(22) Anmeldetag: 20.12.2010
(51) Int. Cl.: H01L 25/16, H01L 23/31, H01L 21/56, H01L 23/00, H01L 25/065, H01L 29/84, B81B 7/00

(54) **HALBLEITER-BAUELEMENT UND ENTSPRECHENDES HERSTELLUNGSVERFAHREN**
SEMICONDUCTOR COMPONENT AND CORRESPONDING PRODUCTION METHOD
ÉLÉMENT À SEMI-CONDUCTEUR ET PROCÉDÉ DE FABRICATION CORRESPONDANT

(30) Priorität: 09.02.2010 DE 102010001711
(43) Veröffentlichungstag der Anmeldung: 19.12.2012
(73) Patentinhaber: Robert Bosch GmbH, 70442 Stuttgart (DE)
(72) Erfinder: EHRENPFORDT, Ricardo, 08056 Zwickau (DE)
(86) Internationale Anmeldenummer: PCT/EP2010/070278
(87) Internationale Veröffentlichungsnummer: WO 2011/098187

(56) Entgegenhaltungen:
- EP-A1- 1 717 562
- WO-A1-2006/036250
- US-A1- 2009 278 215
- US-A1- 2010 252 923

## Beschreibung

### Stand der Technik

Die vorliegende Erfindung betrifft ein Halbleiter-Bauelement und ein entsprechendes Herstellungsverfahren.

Obwohl auf beliebige Halbleiter-Bauelemente anwendbar, werden die vorliegende Erfindung sowie die ihr zugrundeliegende Problematik in Bezug auf einen mikromechanischen Drucksensor erläutert.

Die US 2009/0278215 A1 offenbart eine micromechanische Vorrichtung mit einem Sensor, welcher von einem Schutzgehäuse seitlich umgrenzt wird.

Die DE 10 2006 026 881 A1 offenbart ein Montagekonzept für einen Absolutdrucksensor in Open-Cayity-Full-Mold-Technik. Bei diesem Montagekonzept wird ein Chip auf einem Leadframe befestigt, drahtgebondet und so mit einer Moldmasse umspritzt, dass der Sensorchip zum Teil aus der Moldmasse herausragt. Im nicht umspritzten Teil befindet sich die Sensormembran.

Üblicherweise werden mikromechanische Sensorvorrichtungen in Moldgehäusen aus Kunststoff verpackt. Dabei verwendet man einerseits sogenannte leaded Gehäuse, welche gebogene Kontaktfüße für die Kontaktierung der nächsten Ebene aufweisen und komplett den oder die Chips ummolden. Andererseits gibt es die sogenannten ühermoldeten leadless Gehäuse, welche sich durch die fehlenden Kontaktbeinchen auszeichnen. Die Kontaktierung der nächsten Ebene wird dabei über Kontaktflächen an der Unterseite der Verpackung realisiert. Das Grundsystem dieser gemoldeten Verpackungsvarianten besteht dabei in der Regel aus einem Substrat (Cu, FR4), einem Kleber, den oder dem Siliziumchip(s) und der Moldmasse.

Eine weitere Verpackungsvariante sind kostenintensive Premoldgehäuse. Dabei handelt es sich um vorgefertigte spritzgegossene Grundgehäuse, welche nach dem Setzen und Kontaktieren der Halbleiterchips mit einem Deckel verschlossen werden. Die Premoldgehäuse stellen sich dabei als stressarme Verpackungsform dar, da kein direkter Kontakt zwischen den Verbundpartnern Silizium und Moldmasse besteht. Des Weiteren stellt sich die vorhandene Kavität innerhalb der Verpackung verbunden mit einer Öffnung in der Verpackung als interessant und zweckmäßig für Medienzugänge dar, wie sie beispielsweise für Drucksensoren, IR-Sensoren und Mikrophone benötigt werden.

Hinsichtlich der Kostenfrage gibt es Bestrebungen, Medienzugänge und Kavitäten auch in Fullmold-Verpackungen (vollständig ummoldet) zu realisieren. Bei einem ersten Konzept wird das sog. Filmmoldverfahren angewandt. Dabei wird der Medienzugang über die Form des Moldwerkzeuges realisiert. Eine hervorstehende Werkzeugstruktur setzt direkt auf dem Halbleiterchip auf und verhindert das Übermolden in diesem Bereich, beispielsweise im Bereich einer Drucksensor-Membran. Zum Toleranzausgleich ist das Moldwerkzeug mit einem ETFE-Film (ETFE = Ethylen-Tetrafluor-ethylen) überzogen. Dieser ist stark deformierbar und legt sich formtreu über die Werkzeugoberfläche. Bei diesem Verfahren gibt es eine direkte Abhängigkeit zwischen Sensorlayout und Werkzeugstrukturen. Das Werkzeug muss die aktiven Membranstrukturen abdecken, ohne jedoch Padflächen oder Drahtbonds abzudecken. Somit sind bestimmte Designregeln einzuhalten. Des Weiteren könnte je nach Layout auch ein vollständiges Aufsetzen des Werkzeugs auf die aktiven Strukturen, wie beispielsweise Membranen, nötig werden und zu mechanischen Belastungen führen. Bei diesem Verfahren sind keinerlei Hinterschnitte bei den Kavitäten realisierbar.

Ein weiteres Konzept basiert auf dem Einsatz eines Laminat-basierten Substrats in Verbindung mit einer Kontaktierung über Flipchip- und Underfill-Technologie. Der mechanische und elektrische Kontakt des Sensors zum Substrat wird dabei über Lotkugeln oder Studbumbs und eine Unterfüllung hergestellt. Die Drucksensormembran bleibt unbedeckt und erhält über einen Durchbruch im Substrat den Medienzugang. Allerdings zeichnet sich vor allem der Punkt der Unterfüllung als kritisch aus. Um die Membran nicht mit der Unterfüllung zu bedecken, nutzt man den abbrechenden Kapillareffekt an der Kante eines Substratdurchganges aus. Somit sind die Größe und Kantenform des Durchganges indirekt an den Fließweg der Unterfüllung (und umgekehrt) und somit die Funktion der Sensormembran gekoppelt. Zudem zieht sich die Unterfüllung im ausbildenden Meniskus zur Membran hin und verbraucht somit ungenützte Sensorfläche.

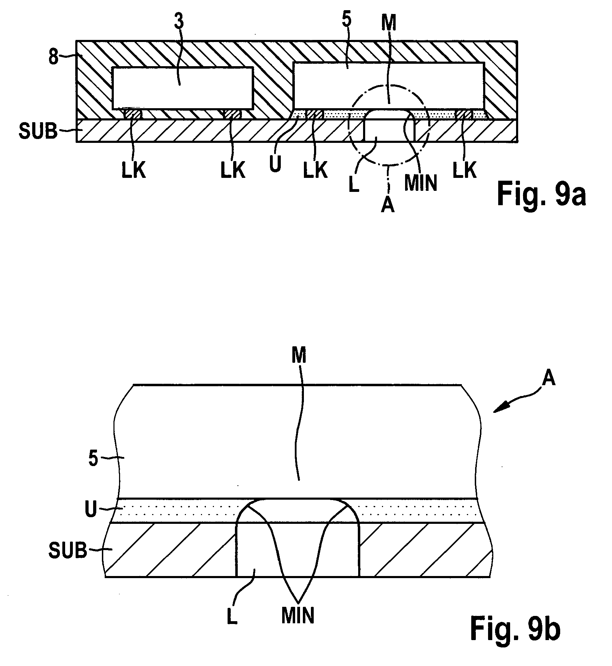

Fig. 9a,b sind Querschnittsansichten, eines beispielhaften Halbleiter-Bauelements in Form einer mikromechanischen Drucksensoranordnung, wobei Fig. 9b eine Ausschnittsvergrösserung des Bereichs A von Fig. 9 darstellt.

In Fig. 9a, b bezeichnet Bezugszeichen SUB ein Leiterplattensubstrat, auf das ein Auswertechip 3 und ein mikromechanischer Drucksensorchip 5 mittels Lotkügelchen LK aufgebracht sind. Unter dem mikromechanischen Drucksensorchip 5 ist eine Unterfüllung U vorgesehen, welche zur mechanischen Stabilisierung dient. Beide Chips 3, 5 sind in einer Moldverpackung 8 aus Moldmasse bzw. Pressmasse eingepackt. Der Membranbereich M des Drucksensorchips 5 wird frei von Unterfüllung U gehalten, weil ein Durchgangsloch L im Substrat an der entsprechenden Stelle vorgesehen ist. Wie aus Fig. 9b erkenntlich, bildet die Unterfüllung U zwischen der Kante am Durchgangsloch L und dem mikromechanischen Drucksensorchip 5 einen Meniskus MIN aus, was zu einem erhöhten Platzbedarf führt.

### Vorteile der Erfindung

Das erfindungsgemäße Halbleiter-Bauelement nach Anspruch 1 und das entsprechende Herstellungsverfahren nach Anspruch 8 weisen gegenüber den bekannten Lösungsansätzen den Vorteil auf, dass ein einfacher kostengünstiger und stressentkoppelter Aufbau ermöglicht wird.

Die der vorliegenden Erfindung zugrundeliegende Idee besteht in einem Vorsehen des Bondmaterials auf Waferebene und einem späteren selektiven Entfernen des Bondmaterials gegenüber Substrat, Moldverpackung und Halbleiterchip auf Bauelementebene oder Baugruppenebene, wodurch der Halbleiterchip derart in der Moldverpackung über dem Substrat aufgehängt ist, dass ein Hohlraum, in dem kein flüssiges oder festes Medium vorgesehen ist, den Halbleiterchip vom Substrat mechanisch entkoppelt. Dadurch können keine direkten Spannungen mehr zwischen Halbleiterchip und Substrat auftreten. Der Halbleiterchip ist lediglich noch mit dem Verbundpartner Moldmasse in der Moldverpackung stabil gekoppelt.

In den Unteransprüchen finden sich vorteilhafte Weiterbildungen und Verbesserungen des jeweiligen Gegenstandes der Erfindung.

Die vorliegende Erfindung ermöglicht eine Entkoppelung des Verbundsystems in der Moldverpackung und zugleich die Herstellung einer Kavität als möglichen Medienzugang im Falle von mikromechanischen Sensorchips, welche einen derartigen Medienzugang benötigen.

Bei einer besonders bevorzugten Ausführungsform wird das Bondmaterial-auf die Unterseite des Wafers mit den Halbleiterchips, welche später dem Substrat zugewandt ist, aufgeschleudert. Nach der Vereinzelung des Wafers in die einzelnen Halbleiterchips kann die Bestückung des Substrats vollautomatisch durchgeführt werden, ohne dass ein zusätzlicher Kleber hinzudosiert werden muss.

Die erfindungsgemäße Verpackung benötigt keinerlei Standardchipbondtechnologie, wie Kleber- oder Flipchip-Technik. Dies führt zu einer Material- und Kostenersparnis. Die Prozessdauer des Bondens des Halbleiterchips auf das Substrat mittels des bevorzugten Polymers als Bondmaterial liegt bei nur 0,5 bis 3 Sekunden, welche zum Aufschmelzen des Bondmaterials benötigt werden. Der spannungsempfindliche Halbleiterchip hat nur noch einen Verbundpartner, die Moldmasse, statt drei Verbundpartnern wie beim Stand der Technik. Der verbleibende Verbundpartner, die Moldmasse, ist zudem am besten an das Halbleiter, beispielsweise Silizium, angepasst. Es ist keine Strukturierung des Bondmaterials notwendig.

Der Hohlraum, der durch die Entfernung des Bondmaterials entsteht, kann nicht nur als Medienzugang, sondern insbesondere auch als Freiraum zur Kompensation von Verformungen des Verbundes dienen, sodass derartige Verformungen den Halbleiterchip nicht beeinflussen. Die Höhe des Hohlraums zwischen Halbleiterchip und Substrat kann ohne großen Aufwand über die Dicke der aufgebrachten Bondmaterialschicht und die Bestückungsparameter der automatischen Bestückungsvorrichtung eingestellt werden.

Insbesondere für ein Halbleiter-Bauelement in Form einer Drucksensorvorrichtung ergeben sich somit folgende weiteren Vorteile. Es sind keine speziellen Moldwerkzeuge notwendig. Somit sind keine Layoutentkopplungen (Werkzeug-Drucksensormembran) notwendig und es gibt keine enge Toleranzkette beispielsweise bei der Positionierung der Sensorchips. Die Membran muss nicht direkt über dem Medienzugang liegen, was einen besseren Schutz der Membran gegenüber von Partikeln, Licht, usw. bedingt. Zudem sind keine mechanischen Belastungen der Membran durch Werkzeugkontakt gegeben. Es ist kein spezielles Moldverfahren, wie z. B. das Filmmolden, notwenig, und es gibt keinerlei Effekte wie z. B. Membranrandbedeckungen durch eine Unterfüllung. Die Größe des Medienzuganges kann durch das Layout des Durchgangs des Substrats frei gewählt werden.

Als selektiv entfernbares bzw. zersetzbares Bondmaterial wird vorzugsweise ein Polymer verwendet. Als mögliche Polymere kommen insbesondere thermisch zersetzbare Polymere, wie z. B. polyzyklische Olefine in Betracht. Diese zeichnen sich durch eine vergleichbar niedrige Zersetzungstemperatur ≥ 100° C aus. Sie zersetzen sich in der Regel rückstandsfrei in gasförmige Reaktionsprodukte, wie z. B. CO₂, CO und H₂. Zudem sind sie wie Standardlacke aufschleuderbar und strukturierbar.

### Zeichnungen

Ausführungsbeispiele der Erfindung sind in den Zeichnungen dargestellt und in der nachfolgenden Beschreibung näher erläutert.

Es illustrieren:
- Fig. 1: eine Querschnittsansicht eines Halbleiter-Bauelements in Form einer mikromechanischen Drucksensoranordnung gemäß einer ersten Ausführungsform der vorliegenden Erfindung;
- Fig. 2: eine Querschnittsansicht eines Halbleiter-Bauelements in Form einer Drehratensensoranordnung gemäß einer zweiten Ausführungsform der vorliegenden Erfindung;
- Fig. 3: eine Querschnittsansicht eines Halbleiter-Bauelements in Form einer mikromechanischen Drehratensensoranordnung gemäß einer dritten Ausführungsform der vorliegenden Erfindung;
- Fig. 4: eine Querschnittsansicht eines Halbleiter-Bauelements in Form einer mikromechanischen Drehratensensoranordnung gemäß einer vierten Ausführungsform der vorliegenden Erfindung;
- Fig. 5: eine Querschnittsansicht eines Halbleiter-Bauelements in Form einer mikromechanischen Drehratensensoranordnung gemäß einer fünften Ausführungsform der vorliegenden Erfindung;
- Fig. 6: eine Querschnittsansicht eines Halbleiter-Bauelements in Form einer mikromechanischen Drucksensoranordnung gemäß einer sechsten Ausführungsform der vorliegenden Erfindung;
- Fig. 7a-d: Querschnittsansichten aufeinanderfolgender Prozessstadien bei einem Herstellungsverfahren für das Halbleiter-Bauelement gemäß Fig. 1 gemäß einer siebenten Ausführungsform der vorliegenden Erfindung;
- Fig. 8a-d: Querschnittsansichten aufeinanderfolgender Prozessstadien bei einem Herstellungsverfahren für das Halbleiter-Bauelement gemäß Fig. 6 gemäß einer achten Ausführungsform der vorliegenden Erfindung; und
- Fig. 9: Querschnittsansichten eines beispielhaften Halbleiter-Bauelements in Form einer mikromechanischen Drucksensoranordnung, wobei Fig. 9b eine Ausschnittsvergrösserung des Bereichs A von Fig. 9 darstellt

### Beschreibung der Ausführungsbeispiele

In den Figuren bezeichnen gleiche Bezugszeichen gleiche oder funktionsgleiche Komponenten.

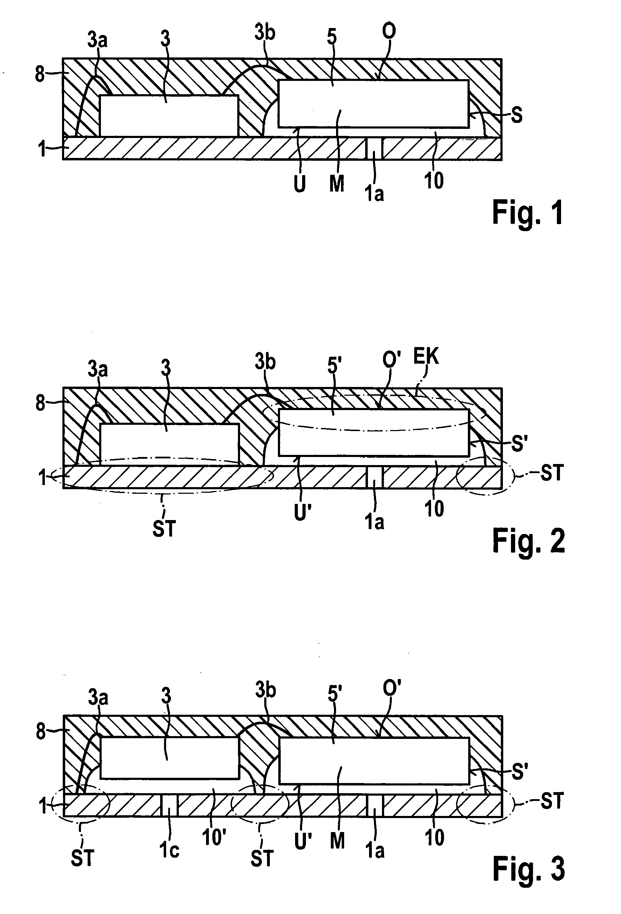

Fig. 1 ist eine Querschnittsansicht eines Halbleiter-Bauelements in Form einer mikromechanischen Drucksensoranordnung gemäß einer ersten Ausführungsform der vorliegenden Erfindung.

In Fig. 1 bezeichnet Bezugszeichen 1 ein Leiterplattensubstrat, auf dem ein Auswertechip 3 angebracht ist, der über einen Bonddraht 3a mit dem Substrat 1 und über einen Bonddraht 3b mit einem mikromechanischen Drucksensorchip 5 verbunden ist. Der mikromechanische Chip 5 ist in einer Moldverpackung 8 aus einer Pressmasse aus Kunststoff an seiner Oberseite O und in einem Teilbereich seiner lateralen Seite S in direktem Verbundkontakt zum Silizium derart aufgehängt, dass ein Hohlraum 10 den mikromechanischen Drucksensorchip 5 vom Substrat mechanisch entkoppelt.

Mit anderen Worten steht der mikromechanische Drucksensorchip 5 an seiner Unterseite U und an Teilbereichen seiner Seitenfläche S nicht in Kontakt mit dem Substrat 1. Lediglich im Bereich seiner Oberseite O und im oberen Bereich seiner lateralen Seiten S ist er in der Moldverpackung 8 aufgehängt. Bezugszeichen 1 a bezeichnet einen Durchgang durch das Substrat 1, welcher als Medienzugang für den mikromechanischen Drucksensorchip 5 dient. Bemerkenswerterweise liegt der Membranbereich M des mikromechanischen Drucksensorchips 5 nicht unmittelbar oberhalb des Durchganges 1a, sondern ist seitlich versetzt davon angeordnet, sodass er gegenüber externen Einflüssen, wie z. B. Partikeln, Licht, Handling usw. geschützt ist.

Fig. 2 ist eine Querschnittsansicht eines Halbleiter-Bauelements in Form einer mikromechanischen Drehratensensoranordnung gemäß einer zweiten Ausführungsform der vorliegenden Erfindung.

Bei der in Fig. 2 gezeigten Ausführungsform ist anstelle des mikromechanischen Drucksensorchips 5 ein anderer mikromechanischer Sensorchip 5', beispielsweise ein Drehratensensor, vorgesehen. Die Aufhängung über dessen Oberseite O' sowie Teile dessen lateraler Seiten S' in der Moldverpackung 8 unter Bildung des Hohlraums 5 an seiner Unterseite U' und den unteren Teilen seiner lateralen Seiten S' ist analog zur ersten Ausführungsform gemäß Fig. 1.

Bezugszeichen ST bezeichnen Bereiche, in denen es zu thermisch induzierten Spannungen kommen kann. Diese treten vor allem unterhalb des Auswertechips 3 auf, der direkt bzw. über Klebe- bzw. über Flip-Chip-Technik mit dem Substrat 1 verbunden ist. Hingegen bleibt der mikromechanische Sensorchip 5' davon unberührt, da er lediglich im Bereich EK an der Moldverpackung 8 aufgehängt ist, welche thermomechanisch gut an das Silizium angepasst ist.

Fig. 3 ist eine Querschnittsansicht eines Halbleiter-Bauelements in Form einer mikromechanischen Drehratensensoranordnung gemäß einer dritten Ausführungsform der vorliegenden Erfindung.

Die dritte Ausführungsform gemäß Fig. 3 unterscheidet sich dadurch von der zweiten Ausführungsform gemäß Fig. 2, dass auch der Auswertechip 3 in der Moldmasse der Moldverpackung 8 aufgehängt ist und ein weiterer Hohlraum unterhalb des Auswertechips 3 vorgesehen ist, der den Auswertechip 3 mechanisch vom Substrat 1 entkoppelt. Somit verringert sich der große spannungsbelastete Bereich ST von Fig. 2 in zwei kleine spannungsbelastete Teilbereiche ST in Fig. 3, welche allerdings nicht an den Auswertechip 3 angrenzen, sondern lediglich an die Moldverpackung 8 aus Kunststoff, so dass die Verbundfläche zwischen Leiterplatte und Moldverpackung verringert ist.

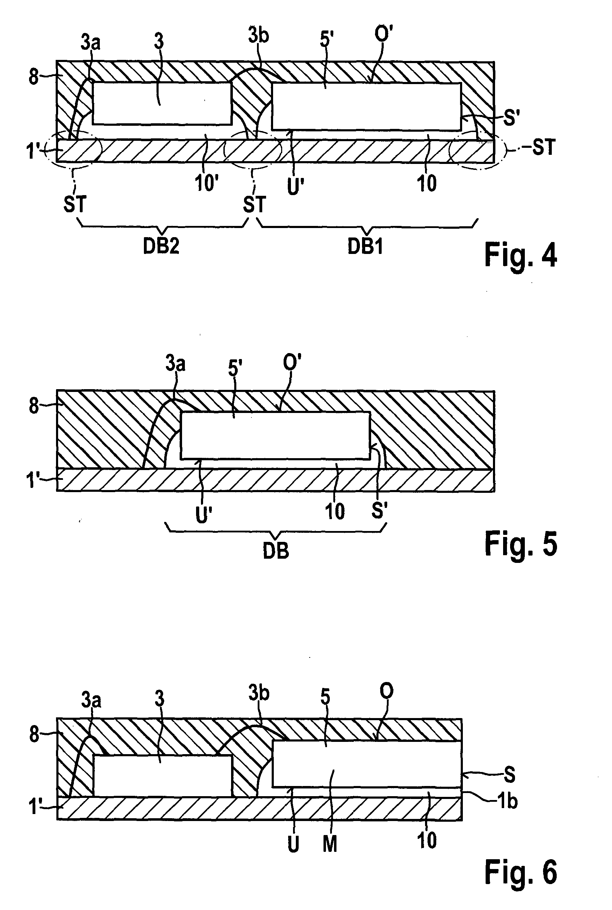

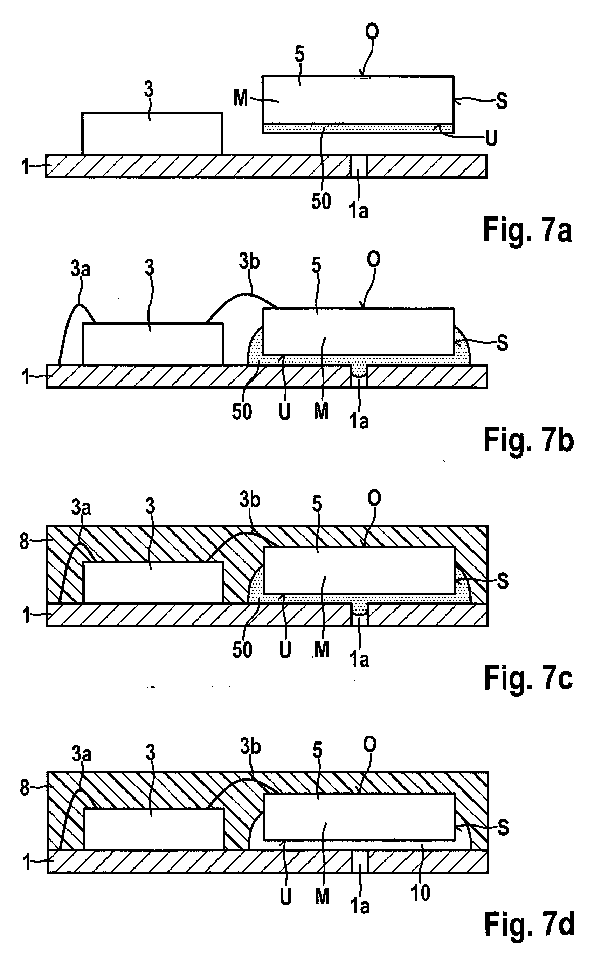

Zusätzlich vorgesehen ist bei der dritten Ausführungsform gemäß Fig. 3 ein weiterer Durchgang 1c im Substrat 1 unterhalb des Auswertechips 3. Die Durchgänge 1a bzw. 1a und 1 c bei der oben beschriebenen ersten bis dritten Ausführungsform hängen neben ihrer Eignung als Medienzugang auch mit dem Herstellungsverfahren der betreffenden mikromechanischen Bauelemente zusammen, wie später in Zusammenhang mit Fig. 6 und 7 erläutert wird.

Fig. 4 ist eine Querschnittsansicht eines Halbleiter-Bauelements in Form einer mikromechanischen Drehratensensoranordnung gemäß einer vierten Ausführungsform der vorliegenden Erfindung.

Bei der vierten Ausführungsform gemäß Fig. 4 sind im Gegensatz zu der dritten Ausführungsform gemäß Fig. 3 die Durchgänge 1a, 1c nicht im Substrat 1'vorgesehen. Anstattdessen sind mit DB1, DB2 Diffusionsbereiche im Substrat 1' gekennzeichnet, welche später im Zusammenhang mit den Ausführungsformen des erfindungsgemäßen Herstellungsverfahrens für ein Halbleiter-Bauelement näher erläutert werden.

Fig. 5 ist eine Querschnittsansicht eines Halbleiter-Bauelements in Form einer mikromechanischen Drehratensensoranordnung gemäß einer fünften Ausführungsform der vorliegenden Erfindung.

Bei der fünften Ausführungsform gemäß Fig. 5 ist lediglich ein einziger mikromechanischer Sensorchip, beispielsweise ein Drehratensensor, in der Moldverpackung 8 über dem Substrat 1', welches keinen Durchgang aufweist, aufgehängt. In Fig. 5 bezeichnet Bezugszeichen DB analog zur vierten Ausführungsform gemäß Fig. 4 ebenfalls einen Diffusionsbereich, welcher später erläutert wird.

Fig. 6 ist eine Querschnittsansicht eines Halbleiter-Bauelements in Form einer mikromechanischen Drucksensoranordnung gemäß einer sechsten Ausführungsform der vorliegenden Erfindung.

Bei der sechsten Ausführungsform gemäß Fig. 6 ist im Unterschied zur ersten Ausführungsform gemäß Fig. 1 kein Durchgang 1a im Substrat 1' vorgesehen, sondern es gibt einen seitlichen Zugang 1 b, über den der Hohlraum 10 von außen zugänglich ist. Dieser seitliche Zugang 1 b wird im Zusammenhang mit dem Herstellungsverfahren gemäß Fig. 7a - d näher erläutert werden.

Fig. 7a-d sind Querschnittsansichten aufeinanderfolgender Prozessstadien bei einem Herstellungsverfahren für das Halbleiter-Bauelement gemäß Fig. 1 gemäß einer siebenten Ausführungsform der vorliegenden Erfindung.

Im anfänglichen Prozessstadium gemäß Fig. 7a wird der Auswertechip 3 auf das Substrat 1 aufgebracht, und zwar beispielsweise in Klebetechnik. Dies erfolgt in einem Bauelementeverbund für eine Vielzahl von Bauelementen auf dem Substrat 1.

Der mikromechanische Drucksensorchip 5 erhält im letzten Prozessschritt der Waferprozessierung vor dem Sägen eine Polymerschicht 50 aus einem polyzyklischen Olefin durch Aufschleudern auf seiner Unterseite U, die später dem Substratl zugewandt ist. Die Schichtdicke des Bondmaterials 50 in Verbindung mit den Bondparametern bestimmt später die Höhe des erzeugten Hohlraums 10 im fertig prozessierten mikromechanischen Bauelement. Nach der Vereinzelung des Wafers mit den mikromechanischen Drucksensorchips 5 wird ein mikromechanischer Drucksensorchip im vorgesehenen Montagebereich oberhalb des Durchgangs 1 a im Substrat 1 aufgebracht.

Wie in Fig. 7b illustriert, erfolgt bei dem Aufbringen ein Aufbonden mit einer beheizten Bestückungsvorrichtung unter definierten Parametern, wie z. B. Temperatur, Kraft, Haltezeit usw. auf dem Substrat 1, wobei das Bondmaterial 50 aufgeschmolzen wird. Typische Haltezeiten dafür liegen im Bereich von 0,5 - 3 Sekunden. Es ist keinerlei Einsatz von zusätzlichen Klebern, verbunden mit einem Dispensen und einem zeitaufwändigen Auspackschritt von typischerweise einer Stunde, notwendig. Nach dem anschließenden Drahtbonden der Bondverbindungen 3a, 3b zwischen Substrat und Auswertechip bzw. zwischen Auswertechip und Drucksensorchip 5 wird das System gemoldet. Dieser Molding- Prozessschritt dauert bei einer Temperatur von 170°C nur ca. ein bis zwei Minuten, wobei das Bondmaterial 50 dabei positions- und formstabil als Bondschicht zwischen dem Drucksensorchip 5 und dem Substrat 1 verbleibt.

Durch das Aufbonden mit dem Bondmaterial 50 ergeben sich in Abhängigkeit der Schichtdicke des Bondmaterials 50 und der Bondparameter leichte Menisken an den lateralen Seiten S des mikromechanischen Drucksensorchips 5.

In einem folgenden Schritt erfolgt ein Vereinzeln der Bauelemente durch einen Sägeschritt.

Im anschließenden PMC (Post-Mold-Cure)-Temperaturschritt, welcher standardmäßig zur Endvernetzung der Moldverpackung 8 durchgeführt wird, wird das Bondmaterial 50 rückstandsfrei in gasförmige Produkte zersetzt und kann somit selektiv entfernt werden. Die entstehenden gasförmigen Produkte entweichen über den Durchgang 1 a im Substrat.

Das Entfernen des Bondmaterials 50 nach dem Sägeschritt hat den Vorteil, dass während des gesamten Montageprozesses eine Schutzfunktion durch das Bondmaterial für empfindliche Chipelemente an der Unterseite U, wie z.B. die Membran M, ausgeübt werden kann.

Ist dies nicht erforderlich, kann das Entfernen des Bondmaterials 50 auch vor dem Sägeschritt erfolgen.

Der entstehende Hohlraum 10 bildet einen Medienzugang für den Drucksensorchip 5 und sorgt zum anderen für die Entkopplung des stressempfindlichen Drucksensorchips 5 vom Substrat 1. Einzig verbleibender Verbundpartner für den Drucksensorchip 5 ist das thermisch am besten an das Silizium angepasste Moldcompound der Moldverpackung 8. Die thermische Mismatch und die Verwölbung werden durch die Entkopplung vom Substrat 1 deutlich verringert. Zudem werden etwaige Verformungen aus dem Verbund Moldverpackung-Substrat durch die Entkopplung nicht- bzw. nur eingeschränkt an den Drucksensorchip 5 weitergegeben. Bei ausreichend geringem Moldüberzug über dem Drucksensorchip 5 wird das Silizium zudem dominierend und somit stressfrei.

Obwohl bei der im Zusammenhang mit Fig. 7a-d beschriebenen Ausführungsform das selektive Entfernen des Bondmaterials 50 simultan mit dem PMC-Temperaturschritt erfolgte, ist dies natürlich nicht unbedingt erforderlich, sondern kann auch in einem separaten Temperaturschritt erfolgen.

Zudem sei mit Rückblick auf Fig. 4 und 5 erwähnt, dass anstelle der Durchgänge 1a bzw. 1a und 1 c im Substrat auch Diffusionsbereiche im Substrat 1' vorliegen können, durch die die gasförmigen Zersetzungsprodukte des Bondmaterials 50 entweichen können. Diese Diffusionsbereiche DB1, D2 bzw. DB können entweder speziell strukturierte Bereiche sein, oder aber können im Fall eines stark diffusionsdurchlässigen Substrats 1' ganz normale Substratbereiche sein, die sich von ihrer Umgebung nicht unterscheiden.

Weiterhin sollte erwähnt werden, dass die Erfindung nicht auf eine thermische Zersetzung des Bondmaterials beschränkt ist, sondern auch eine chemische und/oder physikalische Zersetzung, wie z. B. durch ein Lösungsmittel oder ein Ätzmittel oder ein Plasma, einschließt.

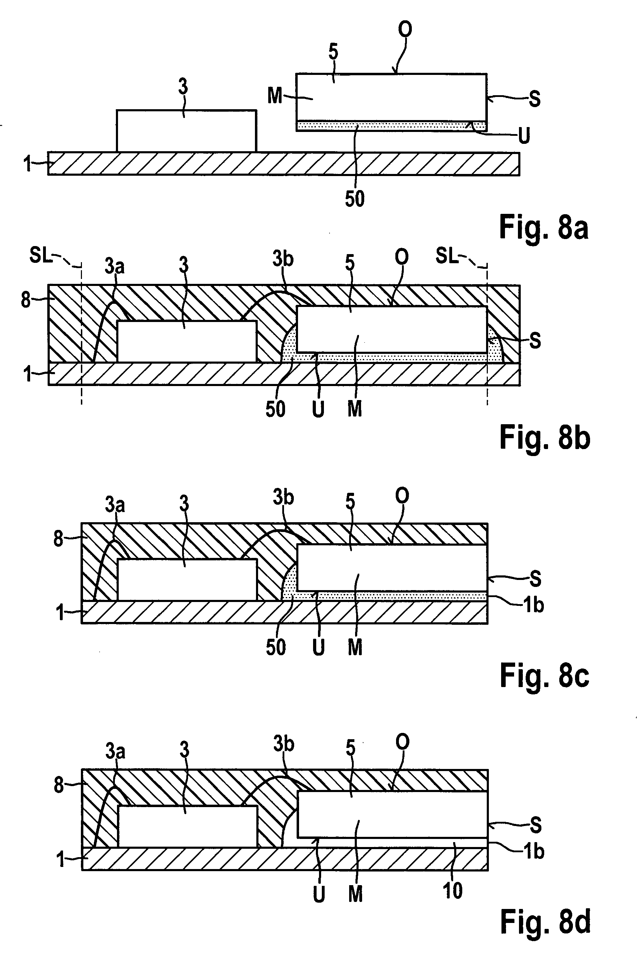

Fig. 8a-d sind Querschnittsansichten aufeinanderfolgender Prozessstadien bei einem Herstellungsverfahren für das Halbleiter-Bauelement gemäß Fig. 6 gemäß einer achten Ausführungsform der vorliegenden Erfindung.

Bei der in Fig. 8a - d dargestellten Ausführungsform entsprechen die Prozessschritte, welche in Fig. 8a und 8b dargestellt sind, den entsprechenden Prozessschritten gemäß Fig. 7a und 7b, welche bereits oben erläutert wurden.

In Fig. 8b bezeichnet Bezugszeichen SL eine Sägelinie, entlang der zum Erreichen des Prozesszustandes gemäß Fig. 8c ein Sägevorgang durchgeführt wird. Bei diesem Sägevorgang entsteht ein seitlicher Zugang 1 b zum Bondmaterial 50. Zweckmäßigerweise wird vor dem Sägevorgang der Drucksensorchip 5 etwas versetzt zur Sägelinie SL positioniert, sodass beim Sägen ein minimaler Randbereich der lateralen Seite S des Drucksensorchips abgetragen wird.

Im Anschluss an den Prozesszustand gemäß Fig. 8c erfolgt dann wie bei der oben beschriebenen siebten Ausführungsform ein selektives Entfernen des Bondmaterials 50 zur Erzeugung des Hohlraums 10 entweder durch einen thermischen Prozess oder einen chemischen und/oder physikalischen Prozess. Es entsteht somit ein spannungsentkoppeltes Sensorpackage mit seitlichem Zugang 1 b für entsprechende Medien, wie z. B. Atmosphärendruck.

Obwohl die vorliegende Erfindung vorstehend anhand bevorzugter Ausführungsbeispiele erläutert worden ist, ist sie nicht darauf beschränkt, sondern auch in anderer Weise ausführbar.

Die Erfindung ist selbstverständlich nicht auf die erwähnten mikromechanischen Sensorchips beschränkt, sondern prinzipiell auf beliebige Halbleiterchips anwendbar.

Das genannte polyzyklische Olefin ist nur eines von vielen Beispielen für ein selektiv entfernbares Bondmaterial, und es sind zahlreiche Modifikationen denkbar, wie z. B. UV-zersetzbare Bondmaterialien, organisch lösbare Wachse, anorganisch lösbare Substanzen, usw.

## Patentansprüche

1. Halbleiter-Bauelement mit:
einem Substrat (1; 1');
einer Moldverpackung (8); und
einem Halbleiterchip (5; 5'), welcher in der Moldverpackung (8) über dem Substrat (1; 1') an der Moldmasse derart aufgehängt ist, dass ein Hohlraum (10) die gesamte Unterseite (U; U') des Halbleiterchips (5; 5') vom Substrat (1; 1') mechanisch entkoppelt, wobei sich der Hohlraum (10) entlang einer dem Substrat (1; 1') zugewandten Unterseite (U; U') des Halbleiterchips erstreckt.

2. Halbleiter-Bauelement nach Anspruch 1, wobei sich der Hohlraum (10) zumindest teilweise entlang einer sich an die Unterseite (U) anschließenden lateralen Seite (S; S') des Halbleiterchips (5; 5') erstreckt.

3. Halbleiter-Bauelement nach Anspruch 1, wobei der Halbleiterchip (5; 5') ein Drucksensorchip ist, welcher einen Membranbereich (M) aufweist, der in dem Hohlraum (10) angeordnet ist.

4. Halbleiter-Bauelement nach einem der vorhergehenden Ansprüche, wobei das Substrat (1; 1') einen Durchgang (1a) oder einen Diffusionsbereich (DB; DB1, DB2) aufweist, über den der Hohlraum (10) von außen zugänglich ist.

5. Halbleiter-Bauelement nach einem der vorhergehenden Ansprüche, wobei oberhalb des Substrats (1; 1') ein seitlicher Zugang (1 b) vorgesehen ist, über den der Hohlraum (10) von außen zugänglich ist.

6. Halbleiter-Bauelement nach einem der vorhergehenden Ansprüche, wobei in der Moldverpackung (8) mindestens ein weiterer Halbleiterchip (3) vorgesehen ist, der mit dem Halbleiterchip (5; 5') elektrisch verbunden ist.

7. Halbleiter-Bauelement nach Anspruch 6, wobei der weitere Halbleiterchip (3) in der Moldverpackung (8) über dem Substrat (1; 1') an der Moldmasse derart aufgehängt ist, dass ein weiterer Hohlraum (10') den weiteren Halbleiterchip (3) vom Substrat (1; 1') mechanisch entkoppelt.

8. Verfahren zur Herstellung eines Halbleiter-Bauelements mit den Schritten:
Anbringen von Bondmaterial (50) auf Waferlevel auf eine Mehrzahl von Halbleiterchips (5; 5');
Anbringen eines Halbleiterchips (5; 5') auf einem Substrat (1; 1') mittels des Bondmaterials (50);
Verpacken des auf dem Substrat (1:1') angebrachten Halbleiterchips (5; 5') in einer Moldverpackung (8);
selektives Entfernen des Bondmaterials (50), wodurch der Halbleiterchip (5; 5') derart in der Moldverpackung (8) über dem Substrat (1; 1') an der Moldmasse aufgehängt ist, dass ein Hohlraum (10) den Halbleiterchip (5; 5') vom Substrat (1; 1') mechanisch entkoppelt.

9. Verfahren nach Anspruch 8, wobei der Halbleiterchip (5; 5') auf dem Substrat (1; 1') mittels Aufschmelzen des Bondmaterials (50) aufgebracht wird.

10. Verfahren nach Anspruch 8 oder 9, wobei das Bondmaterial (50) thermisch selektiv entfernt wird.

11. Verfahren nach Anspruch 8 oder 9, wobei das Bondmaterial (50) chemisch und/oder physikalisch selektiv entfernt wird.

12. Verfahren nach einem der vorhergehenden Ansprüche 8 bis 11, wobei das Substrat (1; 1') im Bereich des Bondmaterials (50) einen Durchgang (1 a) aufweist, wodurch das Bondmaterial (50) selektiv entfernt wird.

13. Verfahren nach einem der vorhergehenden Ansprüche 8 bis 11, wobei das Substrat (1; 1') im Bereich des Bondmaterials (50) einen Diffusionsbereich (DB; DB1, DB2) aufweist, wodurch das Bondmaterial (50) selektiv entfernt wird.

14. Verfahren nach einem der vorhergehenden Ansprüche 8 bis 11, wobei nach dem Verpacken ein Sägeschritt durchgeführt wird, durch den das Bondmaterials (50) durch einen seitlichen Zugang (1 b) freigelegt wird, wonach das selektive Entfernen des Bondmaterials (50) durch den seitlichen Zugang (1 b) erfolgt.

15. Verfahren nach einem der vorhergehenden Ansprüche 8 bis 14, wobei das Bondmaterial (50) ein polyzyklisches Olefin aufweist.

## Claims

1. Semiconductor component, comprising:
a substrate (1; 1');
a molded package (8); and
a semiconductor chip (5; 5') which is suspended from the molding compound in the molded package (8) above the substrate (1; 1') in such a way that a cavity (10) mechanically decouples the whole lower side (U; U') of the semiconductor chip (5; 5') from the substrate (1; 1'), wherein the cavity (10) extends along a lower side (U; U') of the semiconductor chip facing the substrate (1; 1').

2. Semiconductor component according to Claim 1, wherein the cavity (10) extends at least partially along a lateral side (S; S') of the semiconductor chip (5; 5') adjacent to the lower side (U).

3. Semiconductor component according to Claim 1, wherein the semiconductor chip (5; 5') is a pressure sensor chip that has a membrane region (M) which is arranged in the cavity (10).

4. Semiconductor component according to one of the preceding claims, wherein the substrate (1; 1') comprises an opening (1a) or a diffusion region (DB; DB1, DB2) through which the cavity (10) is externally accessible.

5. Semiconductor component according to one of the preceding claims, wherein a lateral access (1b) is provided above the substrate (1; 1'), through which the cavity (10) is externally accessible.

6. Semiconductor component according to one of the preceding claims, wherein at least one further semiconductor chip (3), which is electrically connected to the semiconductor chip (5; 5'), is provided in the molded package (8).

7. Semiconductor component according to Claim 6, wherein the further semiconductor chip (3) is suspended from the molding compound in the molded package (8) above the substrate (1; 1') in such a way that a further cavity (10') mechanically decouples the further semiconductor chip (3) from the substrate (1; 1').

8. Method for producing a semiconductor component, comprising the steps:
applying bonding material (50) at the wafer level onto a multiplicity of semiconductor chips (5; 5');
applying a semiconductor chip (5; 5') on a substrate (1; 1') by means of the bonding material (50);
packaging the semiconductor chip (5; 5') applied on the substrate (1; 1') in a molded package (8);
selective removal of the bonding material (50), so that the semiconductor chip (5; 5') is suspended from the molding compound in the molded package (8) above the substrate (1; 1') in such a way that a cavity (10) mechanically decouples the semiconductor chip (5; 5') from the substrate (1; 1').

9. Method according to Claim 8, wherein the semiconductor chip (5; 5') is applied on the substrate (1; 1') by melting the bonding material (50).

10. Method according to Claim 8 or 9, wherein the bonding material (50) is selectively removed thermally.

11. Method according to Claim 8 or 9, wherein the bonding material (50) is selectively removed chemically and/or physically.

12. Method according to one of the preceding Claims 8 to 11, wherein the substrate (1; 1') has an opening (1a) in the region of the bonding material (50), so that the bonding material (50) is selectively removed.

13. Method according to one of the preceding Claims 8 to 11, wherein the substrate (1; 1') has a diffusion region (DB; DB1, DB2) in the region of the bonding material (50), so that the bonding material (50) is selectively removed.

14. Method according to one of the preceding Claims 8 to 11, wherein after the packaging, a sawing step is carried out by which the bonding material (50) is exposed through a lateral access (1b), after which the selective removal of the bonding material (50) is carried out through the lateral access (1b).

15. Method according to one of the preceding Claims 8 to 14, wherein the bonding material (50) comprises a polycyclic olefin.

## Revendications

1. Composant semi-conducteur présentant un substrat (1; 1'),
un emballage moulé (8) et
une puce semi-conductrice (5; 5') suspendue au-dessus du substrat (1; 1') sur la masse moulée de l'emballage moulé (8) de telle sorte qu'une cavité (10) découple mécaniquement du substrat (1; 1') la totalité du côté inférieur (U; U') de la puce semi-conductrice (5 ; 5'), la cavité (10) s'étendant le long du côté inférieur (U; U') de la puce semi-conductrice tourné vers le substrat (1; 1').

2. Composant semi-conducteur selon la revendication 1, dans lequel la cavité (10) s'étend au moins en partie le long d'un côté latéral (S; S') de la puce semi-conductrice (5; 5') qui se raccorde au côté inférieur (U).

3. Composant semi-conducteur selon la revendication 1, dans lequel la puce semi-conductrice (5; 5') est une puce de capteur de pression qui présente une zone (M) en membrane disposée dans la cavité (10).

4. Composant semi-conducteur selon l'une des revendications précédentes, dans lequel le substrat (1; 1') présente un passage (1a) ou une zone de diffusion (DB; DB1; DB2) par lesquels la cavité (10) est accessible depuis l'extérieur.

5. Composant semi-conducteur selon l'une des revendications précédentes, dans lequel un accès latéral (1b) par lequel la cavité (10) est accessible depuis l'extérieur est prévu au-dessus du substrat (1; 1').

6. Composant semi-conducteur selon l'une des revendications précédentes, dans lequel au moins une autre puce semi-conductrice (3) raccordée électriquement à la puce semi-conductrice (5; 5') est prévue dans l'emballage moulé (8).

7. Composant semi-conducteur selon la revendication 6, dans lequel l'autre puce semi-conductrice (3) est suspendue au-dessus du substrat (1; 1') sur la masse moulée de l'emballage moulé (8) de telle sorte qu'une autre cavité (10') découple mécaniquement l'autre puce semi-conductrice (3) du substrat (1; 1').

8. Procédé de fabrication d'un composant semi-conducteur, le procédé présentant les étapes qui consistent à :
placer un matériau de liaison (50) au niveau de la galette sur plusieurs puces semi-conductrices (5; 5'),
placer une puce semi-conductrice (5; 5') sur un substrat (1; 1') au moyen du matériau de liaison (50),
emballer dans un emballage moulé (8) la puce semi-conductrice (5; 5') placée sur le substrat (1; 1'),
enlever sélectivement le matériau de liaison (50), suite à quoi la puce semi-conductrice (5; 5') est suspendue au-dessus du substrat (1; 1') sur la masse moulée de l'emballage moulé (8) de telle sorte qu'une cavité (10) découple mécaniquement la puce semi-conductrice (5; 5') du substrat (1; 1').

9. Procédé selon la revendication 8, dans lequel la puce semi-conductrice (5; 5') est appliquée sur le substrat (1; 1') par fusion du matériau de liaison (50).

10. Procédé selon les revendications 8 ou 9, dans lequel le matériau de liaison (50) est enlevé sélectivement par voie thermique.

11. Procédé selon les revendications 8 ou 9, dans lequel le matériau de liaison (50) est enlevé sélectivement par voie chimique et/ou par voie physique.

12. Procédé selon l'une des revendications 8 à 11 qui précèdent, dans lequel le substrat (1; 1') présente au niveau du matériau de liaison (50) un passage (1a) par lequel le matériau de liaison (50) est enlevé sélectivement.

13. Procédé selon l'une des revendications 8 à 11 qui précèdent, dans lequel le substrat (1; 1') présente une zone de diffusion (DB; DB1; DB2) par laquelle le matériau de liaison (50) est enlevé sélectivement.

14. Procédé selon l'une des revendications 8 à 11 qui précèdent, dans lequel une étape de sciage est exécutée après l'emballage pour libérer le matériau de liaison (50) par un accès latéral (1b), suite à quoi l'enlèvement sélectif du matériau de liaison (50) s'effectue par l'accès latéral (1b).

15. Procédé selon l'une des revendications 8 à 14, dans lequel le matériau de liaison (50) présente une oléfine polycyclique.
